(19) Europäisches Patentamt

European Patent Office

Office européen des brevets

(11) Veröffentlichungsnummer: **0 125 329**
**B1**

(12) # EUROPÄISCHE PATENTSCHRIFT

(45) Veröffentlichungstag der Patentschrift:
**09.03.88**

(51) Int. Cl.⁴: **G 01 R 15/07**

(21) Anmeldenummer: **83104797.2**

(22) Anmeldetag: **16.05.83**

(54) **Messwandler auf der Basis des elektro- bzw. magnetooptischen Effektes.**

(43) Veröffentlichungstag der Anmeldung:
**21.11.84 Patentblatt 84/47**

(45) Bekanntmachung des Hinweises auf die Patenterteilung:
**09.03.88 Patentblatt 88/10**

(84) Benannte Vertragsstaaten:
**AT DE FR**

(56) Entgegenhaltungen:
**DE - B - 2 333 242**
**US - A - 3 605 013**

(73) Patentinhaber: **VEB Elektroprojekt und Anlagenbau Berlin, Rhinstrasse 100, DDR-1140 Berlin (DD)**

(72) Erfinder: **Knöschke, Wolfgang, Dipl.-Phys., Karl-Pokern-Strasse 12, DDR-1162 Berlin (DD)**
Erfinder: **Hoier, Bernhard, Dr. Ing., Egon-Schultz-Strasse 70, DDR-1040 Berlin (DD)**
Erfinder: **Bogedale, Gerd, Dipl.-Ing., Dunckerstrasse 35, DDR-1071 Berlin (DD)**

(74) Vertreter: **Patentanwälte Beetz sen. - Beetz jun. Timpe - Siegfried - Schmitt-Fumian, Steinsdorfstrasse 10, D-8000 München 22 (DE)**

## Beschreibung

Die Erfindung betrifft einen Messwandler auf der Basis des elektro- bzw. magnetooptischen Effektes mit einem Messfühler aus einer Lichtwellenleiterspule mit grosser elektro- oder magnetooptischer Konstante als Modulator und einem sich daran anschliessenden Analysator zur Ermittlung einer Drehung der Polarisationsebene des Lichts, wie er gattungsgemäss aus US-A-3 605 013 bekannt ist.

Für die Messung von Strömen oder Spannungen in elektrischen Anlagen sind als nichtkonventionelle Verfahren u.a. Lösungen bekannt, die als Informationsträger zur Überbrückung hoher Potentialdifferenzen Licht verwenden, und bei denen mit der zu messenden Grösse eine Drehung der Polarisationsebene des Lichtes mit Hilfe eines Modulators erzielt wird, der einen elektrooptischen oder Magnetooptischen Effekt aufweist.

Dabei kann als Mass für die zu messende Grösse sowohl der Drehwinkel der Polarisationsebene direkt ausgewertet, als auch mit einer Kompensationsschaltung (zweiter Modulator) die Drehung rückgängig gemacht und die Höhe des Kompensationsstromes bestimmt werden. Als Modulatoren wurden ursprünglich Glasstäbe, z.B. aus Flintglas, verwendet. Infolge ihrer geringen Länge wurden nur geringe Drehwinkel der Polarisationsebene erreicht. Damit ergaben sich Probleme bei der Auswertung der Signale.

Mit der Entwicklung von Lichtwellenleitern, die polarisiertes Licht ohne Zerstörung der Polarisation fortleiten können, und der Entwicklung von Lichtwellenleitern, die gemäss dem Oberbegriff des Anspruchs 1 eine grosse Verdet-Konstante besitzen, ergab sich die Möglichkeit, Modulatoren in Form von Spulen aus derartigen Lichtwellenleitern aufzubauen (DE-A-2 624 692, US-A-3 605 013). Damit können wesentlich grössere Polarisations-Drehwinkel erreicht werden. Für die dabei auftretenden Probleme, Vermeidung der Auswirkungen von Spannungsdoppelbrechung und Formdoppelbrechung in den Lichtwellenleitern, gibt es geeignete Lösungen, z.B. die Anwendung von Lichtwellenleitern mit Flüssigkern (DE-B-2 445 369), bzw. spezielle konstruktive Anordnungen.

So ist in der DE-A-2 845 625 eine Anordnung zur elektrooptischen Spannungsmessung beschrieben, bei der als Zuleitung oder Rückleitung für den polarisierten Lichtstrahl zwischen einem Kopfteil mit dem Hochspannungsleiter und dem Fussteil wenigstens eine Kristallfaser mit longitudinalem, linearen elektrooptischen Effekt aus piezoelektrischem Material vorgesehen ist. Am Hochspannungsleiter ist die Kristallfaser um einen Umlenkkörper geführt, durch dessen Gestaltungsform eine zusätzliche Formdoppelbrechung durch die Krümmung der Kristallfaser verhindert wird.

Bei einem anderen bekannten magnetooptischen Messwandler zur Messung von Strömen, der einen als Lichtleiterspule ausgebildeten Messfühler besitzt, die einen Stromleiter umschliesst, und bei dem der Lichtleiter weitestgehend frei von herstellungsbedingten mechanischen Spannungen ist, wird die Formdoppelbrechung dadurch kompensiert, dass die Lichtleiterspule einen grossen Steigungswinkel aufweist (DE-A-2 548 278).

Auf diese Weise lassen sich bereits Spulen aus Lichtwellenleitern von über 1 km Länge herstellen, durch die polarisiertes Licht ohne wesentliche Depolarisationserscheinungen geleitet werden kann.

Es wird jedoch bei fast allen bekannten Lösungen davon ausgegangen, eine analoge Abbildung der zu messenden Grösse über die Drehung der Polarisationsebene zu erreichen. Dabei sind bei grösseren Drehwinkeln besondere Massnahmen erforderlich, um Linearität in der Messwertabbildung insgesamt zu erreichen. So ist z.B. in der DE-A-2 812 188 ein Verfahren zur magnetooptischen Strommessung beschrieben, bei dem bei einem sinusförmigen Modulationssignal auch für grössere Winkel der Faraday-Drehung dadurch eine Linearität der Messwertabbildung erreicht wird, dass aus dem Messsignal die Grundfrequenz und die erste Oberschwingung des Modulationssignals getrennt herausgefiltert werden, und dass anschliessend das Messsignal demoduliert und dann der Quotient aus den Intensitäten der beiden Signalanteile gebildet wird. Will man die Ausgangssignale des Wandlers jedoch mittels eines Digitalrechners verarbeiten oder an einen zentralen Datenbus ankoppeln, benötigt man im allgemeinen digitalisierte oder binär codierte Signale, so dass den bekannten Einrichtungen somit der Nachteil anhaftet, dass ein digitaler Messwert stets über den Umweg eines analogen elektrischen Signals erhalten wird. Das aber bedeutet, dass aufwendige elektronische Zusatzschaltungen, z.B. Analog-Digital-Umsetzer, erforderlich sind, die jedoch zusätzliche Messfehler mit sich bringen. Aus der DE-B-2 333 242 ist auch bereits ein magnetooptischer Messwandler bekannt, der einen digitalen Messwert abgibt, indem er eine Vielzahl von Modulatoren mit binär abgestuften Stromempfindlichkeiten enthält. Der Aufwand dafür und für die geforderte Gleichheit der Lichtintensitäten in allen optischen Kanälen ist jedoch sehr hoch.

Hier will die Erfindung Abhilfe schaffen. Die Erfindung, wie sie in Anspruch 1 gekennzeichnet ist, löst die Aufgabe, einen Messwandler auf der Basis des elektro- bzw. magnetooptischen Effektes zu schaffen, bei dem eine direkte Umwandlung der Drehung der Polarisationsebene in digitale Ausgangssignale erfolgt, dadurch, dass der Analysator so ausgebildet ist, dass er nur auf eine oder mehrere bestimmte, vorgegebene Winkellagen der Polarisationsebene des Lichtes anspricht und ausserdem die Durchlaufrichtung der Polarisationsebene erkennt, wobei die Lichtwellenleiterspule aus einem Lichtwellenleiter so grosser Länge besteht, dass das beeinflussende elektrische oder magnetische Feld eine so grosse Drehung der Polarisationsebene hervorruft, dass der Analysator für den zu messenden Wert mehrmals zum Ansprechen gelangt, und dass eine Zähleinrichtung vorgesehen ist, die aus einer Logikschaltung, die die Analysatorimpulse erfolgt und die eine Vorwärts- oder Rückwärtsdrehung der Polarisationsebene unterscheidet, und aus einem digitalen Vorwärts- und Rückwärtszähler aufgebaut ist, an dessen parallelen Ausgängen der Messwert in digitaler Form abnehmbar ist.

Anspruch 2 betrifft eine vorteilhafte Ausführungsform.

Durch Aufteilung des modulierten Lichtes auf mehrere Analysatoren mit unterschiedlichen Ansprech-Polarisationswinkeln, deren Ausgangskreise miteinander verknüpft sind, kann für eine bestimmte Drehung der Polarisationsebene eine Vervielfachung der abgegebenen Impulszahl erreicht werden.

Der gleiche Effekt kann erreicht werden, wenn als Analysator eine Einrichtung eingesetzt wird, die mehrere definierte Winkellagen der Polarisationsebene des auftreffenden Lichtes erkennt und jeweils in elektrische Impulse umformt.

Mit dieser Lösung ist erreicht, dass beim Durchlaufen einer bestimmten Winkellage der Polarisationsebene jeweils ein elektrischer Ausgangsimpuls abgegeben wird, der in einem Zählkreis oder Speicher aufsummiert werden kann und somit eine rechnerverarbeitbare Information über die momentane Grösse des Messwertes darstellt. Da jedoch im allgemeinen aus dem Analysatorsignal nicht auf die Richtung der Winkellageänderung der Polarisationsebene geschlossen werden kann, diese Richtung aber darüber entscheidet, ob der zugehörige Impuls mit positivem oder negativem Vorzeichen zur Summenbildung beitragen muss, ist der Analysator, der neben dem Durchlauf der Polarisationsebene des Lichtes durch eine bestimmte Winkellage auch eine Information über die Durchlaufrichtung liefert, erforderlich. Ein solcher Analysator bewertet die Durchlaufrichtung der Polarisationsebene anhand der impulsmässig erfassten vorhergehenden Winkellage der Polarisationsebene.

Die durch die Erfindung erreichten Vorteile sind somit im wesentlichen darin zu sehen, dass eine Digitalisierung des Messwertes nicht mehr über den Umweg eines analogen elektrischen Signals erfolgt. Damit entfallen aber auch zusätzliche Messfehler mit sich bringende aufwendige elektronische Zusatzschaltungen, wie z.B. Analog-Digital-Umsetzer.

Im folgenden wird die Erfindung anhand von ein Ausführungsbeispiel darstellenden Zeichnungen näher erläutert.

Es zeigen:

Figur 1: Ein Schema des Aufbaus eines als Stromwandler vorgesehenen Messwandlers,

Figur 2: einen Analysator der Winkellage und der Änderungsrichtung der Polarisationsebene,

Figur 3: das Ausgangssignal in Abhängigkeit von der Lichtintensität,

Figur 4: eine Darstellung von zeitlichen Impulsfolgen und

Figur 5: eine Schaltung zur Impulsauswertung.

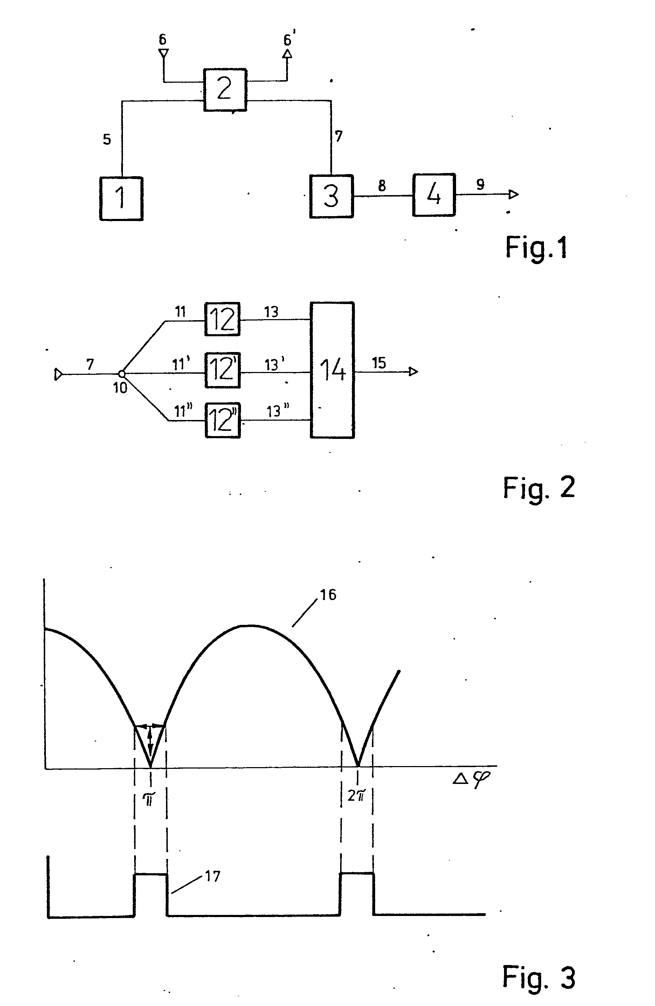

Der als Stromwandler aufgebaute Messwandler nach Figur 1 besteht aus einer Lichtquelle 1, die monochromatisches und linear polarisiertes Licht an einen Lichtwellenleiter 5 abgibt. Dieser Lichtwellenleiter 5 überbrückt die Potentialdifferenz zwischen Erdpotential und Hochspannungspotential des Messstrompfades 6–6' und wird zur Erfassung des Messstromes als Modulator 2 ausgebildet, beispielsweise so, dass der Lichtwellenleiter 5 in einer grossen Länge zu einer Spule aufgewickelt ist, die ihrerseits den Messstrom führenden Leiter umfasst und somit von dessen Magnetfeld beeinflusst wird. Das im Modulator 2 in seiner Polarisationsebene beeinflusste Licht wird über den Lichtwellenleiter 7 in den auf Erdpotential befindlichen Analysator 3 geleitet, der beim Feststellen bestimmter vorgegebener Winkellagen der Polarisationsebene des Lichtes elektrische Impulse an die Leitung 8 abgibt, die in geeigneter Weise in einer Summiereinrichtung 4 aufsummiert, gespeichert und über die Leitung 9 in einer zur Weiterverarbeitung passenden Signalform ausgegeben werden.

Den grundsätzlich gleichen Aufbau weist ein als Spannungswandler dienender Messwandler auf, wobei nur der Modulator 2 konstruktiv so gestaltet ist, dass er vom elektrischem Feld der Hochspannungsleitung beeinflusst wird.

Eine Möglichkeit für die Analyse der Winkellage und der Änderungsrichtung der Polarisationsebene zeigt Figur 2. Das über den Lichtwellenleiter 7 ankommende Licht wird über eine Teilereinrichtung 10 in die drei Teillichtbündel 11, 11', 11'' getrennt, wobei alle Teillichtbündel 11, 11', 11'' weiterhin polarisiert bleiben. Die drei Teilanalysatoren 12, 12', 12'' sind so aufgebaut, dass sie beim Erreichen oder Durchlaufen einer definierten Winkellage der Polarisationsebene des auftreffenden Lichtes einen elektrischen Impuls abgeben, wie in Figur 3 dargestellt. Es wird der Intensitätsverlauf 16 des Lichtes in einem der Teilanalysatoren 12, 12', 12'' dargestellt, wie er vom Winkel $\Delta\phi$ zwischen der Polarisationsebene des einlaufenden Lichtes und der in den Teilanalysatoren 12, 12', 12'' fest eingestellten Richtung des Polarisationsfilters abhängt und in dieser Stärke auf eine photoelektrische Umwandlungseinrichtung fällt, die bei gegen Null gehender Lichtintensität 16 eine Änderung ihres Ausgangssignals 17 vornimmt.

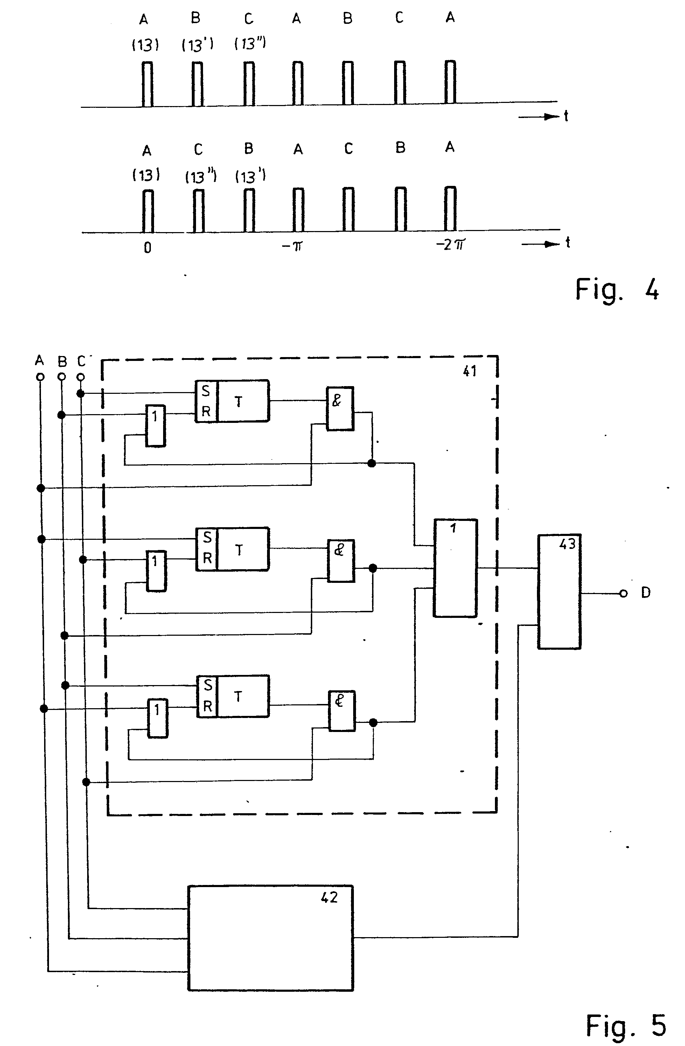

Die fest eingestellten Richtungen der drei Teilanalysatoren 12, 12', 12'' sind im Bereich von 180° so gegeneinander versetzt, dass keine Impulsüberlappung eintritt, vorzugsweise um jeweils 60°. Damit entstehen beim Drehen der Polarisationsebene des Lichtes im Modulator 2 in unterschiedlichen Richtungen die in Figur 4 angegebenen zeitlichen Impulsfolgen 13, 13', 13'', die in der sich anschliessenden Summiereinrichtung 14 bewertet, gespeichert und zu einem Ausgangsimpuls 15 verarbeitet werden.

Figur 5 stellt eine Schaltungsmöglichkeit zur Impulsbewertung dar. Dabei gelangen die Impulse A, B, C aus den drei Teilanalysatoren 12, 12', 12'' in kombinierter Form auf eine Logikschaltung 41, 42, die einen eintreffenden Impuls auf der Grundlage des vorhergehenden Impulses bewertet und damit einen Vorwärts- und Rückwärtszähler 43 speist. Der Zählerstand kann zwischengespeichert und über den Ausgang D abgefragt werden.

**Patentansprüche**

1. Messwandler auf der Basis des elektro- bzw. magnetooptischen Effektes

mit einem Messfühler aus einer Lichtwellenleiterspule mit grosser elektro- oder magnetooptischer Konstante als Modulator (2) und einem sich daran anschliessenden Analysator (3) zur Ermittlung einer Drehung der Polarisationsebene, dadurch gekennzeichnet, dass

– der Analysator (3) so ausgebildet ist, dass er nur auf eine oder mehrere bestimmte, vorgegebene Winkellagen der Polarisationsebene des Lichtes anspricht und ausserdem die Durchlaufrichtung der Polarisationsebene erkennt,

– die Lichtwellenleiterspule aus einem Lichtwellenleiter (5) so grosser Länge besteht, dass das beeinflussende elektrische oder magnetische Feld eine so grosse Drehung der Polarisationsebene hervorruft, dass der Analysator (3) für den zu messenden Wert mehrmals zum Ansprechen gelangt,
und

– eine Zähleinrichtung vorgesehen ist, die aus einer Logikschaltung (41, 42), die die Analysatorimpulse erfasst und die eine Vorwärts- oder Rückwärtsdrehung der Polarisationsebene unterscheidet, und aus einem digitalen Vorwärts- und Rückwärtszähler (43) aufgebaut ist, an dessen parallelen Ausgängen der Messwert in digitaler Form ansteht.

2. Messwandler nach Anspruch 1, dadurch gekennzeichnet, dass mehrere Teilanalysatoren (12, 12', 12'') mit unterschiedlichen Ansprechpolarisationswinkeln vorgesehen sind, deren Ausgänge miteinander verknüpft sind.

**Claims**

1. Measuring transducer based on the electro-optical or magneto-optical effect,

comprising a detector constituted by an optical fibre coil having a large electro-optical or magneto-optical constant as a modulator (2) and a succeeding analyser (3) for detecting a rotation of the plane of polarisation, characterised in that

– the analyser (3) is designed to respond only to one or several certain predetermined angular positions of the plane of polarisation of the light and moreover detects the direction of passage of the plane of polarisation,

– the optical fibre coil is formed of an optical fibre (5) of sufficient length for the influencing electrical or magnetic field to cause such a large rotation of the plane of polarisation that the analyser (3) responds several times to the value which is to be measured,
and

– counting means is provided which is comprised of a logic circuit (41, 42) for detecting the analyser pulses and for discriminating a forward or reverse rotation of the plane of polarisation, and of a digital up-down counter (43) to the parallel outputs of which the measured value is applied in digital form.

2. Measuring transducer as claimed in claim 1, characterised in that plural partial analysers (12, 12', 12'') having different response polarisation angles are provided and have their outputs subjected to logic operation.

**Revendications**

1. Convertisseur de mesure basé sur l'effet électro-optique ou magnéto-optique, avec un capteur de mesure constitué d'une bobine conductrice d'ondes lumineuses avec une constante électro-optique ou magnéto-optique importante agissant comme modulateur (2), et d'un analyseur (3) relié à ce modulateur pour la recherche d'une rotation du plan de polarisation, caractérisé en ce que:

– l'analyseur (3) est formé de telle sorte qu'il réagit seulement à une ou plusieurs positions définies et prédéterminées d'angle du plan de polarisation de la lumière, et qu'en outre il reconnaît la direction de la traversée du plan de polarisation;

– la bobine conductrice d'ondes lumineuses est constituée d'un conducteur (5) d'ondes lumineuses de longueur telle que le champ électrique ou magnétique influent cause une si grande rotation du plan de polarisation que l'analyseur (3) arrive à réagir plusieurs fois pour la valeur à mesurer, et

– un dispositif de comptage est prévu, qui est constitué d'un circuit logique (41, 42), lequel saisit les impulsions de l'analyseur et différencie une rotation antérograde ou rétrograde du plan de polarisation, et d'un compteur numérique antérograde et rétrograde (43), la valeur mesurée étant disponible sous forme numérique aux sorties parallèles de ce compteur.

2. Convertisseur de mesure selon la revendication 1, caractérisé en ce que plusieurs analyseurs partiels (12, 12', 12'') sont prévus et réagissent à différents angles de polarisation, les sorties de ces analyseurs étant réunies ensemble.

Fig.1

Fig. 2

Fig. 3

Fig. 4

Fig. 5